# EUROPEAN PATENT APPLICATION

(11) **EP 2 361 000 A1**
(43) Date of publication of application: **24.08.2011**
(21) Application number: 10153297.6
(22) Date of filing: 11.02.2010
(51) Int. Cl.: H05K 3/00, H05K 3/34, H01L 23/495

(54) **Leadless chip package mounting method and carrier**

(71) Applicant: NXP B.V., 5656 AG Eindhoven (NL)
(72) Inventor: Gulpen, Jan, Redhill, Surrey RH1 1DL (GB); Oberndorff, Pascal, Redhill, Surrey RH1 1DL (GB); van den Boomen, Rene Wilhelmus Johannes Maria, Redhill, Surrey RH1 1DL (GB)
(74) Representative: Burton, Nick

(57) **Abstract**

Disclosed is a method of mounting a leadless chip package (10) on a carrier (50) comprising a plurality of contacts, said package including a package contact (40) bordering an edge (41) of the package for contacting one of said carrier contacts, the method comprising providing a portion of said edge (41) with a coating (42) for improving the affinity of the edge to a solder material (52); and soldering the leadless chip package (10) to one of said carrier contacts using said solder material such that the solder material covers the package contact (40) and the coated edge portion (41). A leadless chip package mounted on an electronic component carrier in accordance with the method of the present invention is also provided.

## Description

### FIELD OF THE INVENTION

The present invention relates to a method of mounting a leadless chip package on a carrier comprising a plurality of contacts, said package including a package contact bordering an edge of the package for contacting one of said carrier contacts.

The present invention further relates to an electronic component carrier carrying such a leadless package.

### BACKGROUND OF THE INVENTION

In various application domains, devices are becoming increasingly reliant on electronic components for their correct functioning. In some application domains, such as for example the automotive industry, electronic components of devices such as vehicles play a key part in the control of the device. For this reason, the electronic components are required to exhibit error-free behavior to ensure that the correct operation of the device is guaranteed.

Consequently, the electronic components are subjected to rigorous testing during the various stages of manufacture. For instance, for an IC to be encapsulated into a package, its operation may be tested when the IC die is still part of a wafer, and may contain structural as well as functional testing. Wafer-level testing has the well-known advantage that all electronic components are still grouped together such that testing can be performed relatively quickly.

The electronic components are subsequently singulated, i.e. the wafer is fragmented into individual dies e.g. by sawing or punching. The singulation step is typically followed by mounting the singulated package onto a carrier such as a printed circuit board (PCB) through soldering, after which another test is required to verify that the solder joints between the PCB and the singulated package are of a sufficient quality. This is typically done by some form of optical inspection.

The ongoing miniaturization of the semiconductor technology form factor has led to the emergence of so-called leadless packages, which are typically manufactured in leadframe strips, with the dies being placed on and connected to the leadframe and encapsulated prior to singulation. As a result, the leads between the leadframe, which is typically used to increase the footprint of the contact area of a die, and the die are encapsulated in the encapsulation material, which typically is a plastic material molded over the strip. The bottom portion of the leadframe, which comprises the contacts for contacting the carrier, is typically treated with e.g. a flux or plated material to improve the wettability of the contacts to the solder used for connecting the package to the carrier.

A problem associated with verification of the mounting process of such leadless packages onto a carrier is that most if not all solder joints between the leadless package and the carrier are invisible due to the fact that the leadless package typically has bottom contacts only. Consequently, the optical inspection of the quality of the solder joints is difficult to achieve.

### SUMMARY OF THE INVENTION

The present invention seeks to provide a method of mounting a leadless chip package on a carrier comprising a plurality of contacts, said package including a package contact bordering an edge of the package for contacting one of said carrier contacts in which the optical inspection of the solder joints can be more easily performed.

The present invention further seeks to provide an electronic component carrier carrying a leadless package for which the solder joints between the electronic component carrier and the leadless package can be more easily inspected.

In accordance to a first aspect of the present invention, there is provided a method of mounting a leadless chip package on a carrier comprising a plurality of contacts, said package including a package contact bordering an edge of the package for contacting one of said carrier contacts, the method comprising providing a portion of said edge with a coating for improving the affinity of the edge to a solder material; and soldering the leadless chip package to one of said carrier contacts using said solder material such that the solder material covers the package contact and the coated edge portion.

The invention is based on the realization that a leadless package having a conductive, e.g. metal contact on an edge of the bottom of the leadless package, the metal contact has a surface portion at the edge of the leadless package, which has been referred to as the edge portion of the leadless package. Hence, by ensuring that the solder joint extends over the edge portion, the quality of the solder joint can be more easily checked by means of optical inspection as the edge portion is typically clearly visible.

However, the inventors have further realized that since such an edge portion typically becomes exposed only when the leadless package is singulated, the edge portion does not benefit from the pre-singulation treatment of the bottom surface to improve the wettability of the conductive contact, such that an additional coating step must be applied to the edge portion once exposed to ensure that the quality of the solder joint on the edge portion is comparable with the quality of the solder joint between the bottom portion of the contact of the leadless package and the carrier.

In an embodiment, a leadframe strip of leadless chip packages is singulated by forming a plurality of trenches in said strip by means of a first partial singulation step such that the edge portions of the respective leadless chip packages are exposed; providing said coating by means of at least one plating step; and completing said singulation step by means of a second partial singulation step. This has the advantage that the coating of the exposed edge portions of the plurality of leadless packages on the strip to improve their wettability may be performed using a single treatment step, thereby reducing the complexity of the method of the present invention.

Advantageously, a saw is used in the second partial singulation step having a smaller cutting width than a saw used in the first partial singulation step. This has the advantage that a process having improved tolerances is obtained, as it is very difficult if not practically impossible to perform a two-step singulation process with a single saw as it is very difficult to align the saw in the second step with the trench formed in the first step. By using a smaller saw, it is easier to align the saw with the already formed trench.

The method may be completed by checking the quality of the soldering step by optically inspecting the solder joint covering the coated edge portion.

According to another aspect of the present invention, there is provided an electronic component carrier comprising a plurality of contacts and a leadless chip package having a package contact bordering an edge of the package, said package contact being soldered to one of said plurality of contacts by a solder joint, wherein said solder joint extends over a coating covering a portion of said edge for optical inspection of the quality of the solder joint. The solder joints of such an assembly can be more easily and more reliably checked by means of visual inspection, as previously explained.

The electronic component carrier may be integrated in an apparatus such as an electronic device or a vehicle.

### BRIEF DESCRIPTION OF THE EMBODIMENTS

Embodiments of the invention are described in more detail and by way of non-limiting examples with reference to the accompanying drawings, wherein:
FIG. 1 schematically depicts a leadless package;
FIG. 2 schematically depicts a problem associated with the optical inspection of solder joints between the leadless package of FIG. 1 and a carrier such as a PCB; and
FIG. 3 schematically depicts an embodiment of the method of the present invention;

### DETAILED DESCRIPTION OF THE DRAWINGS

It should be understood that the Figures are merely schematic and are not drawn to scale. It should also be understood that the same reference numerals are used throughout the Figures to indicate the same or similar parts.

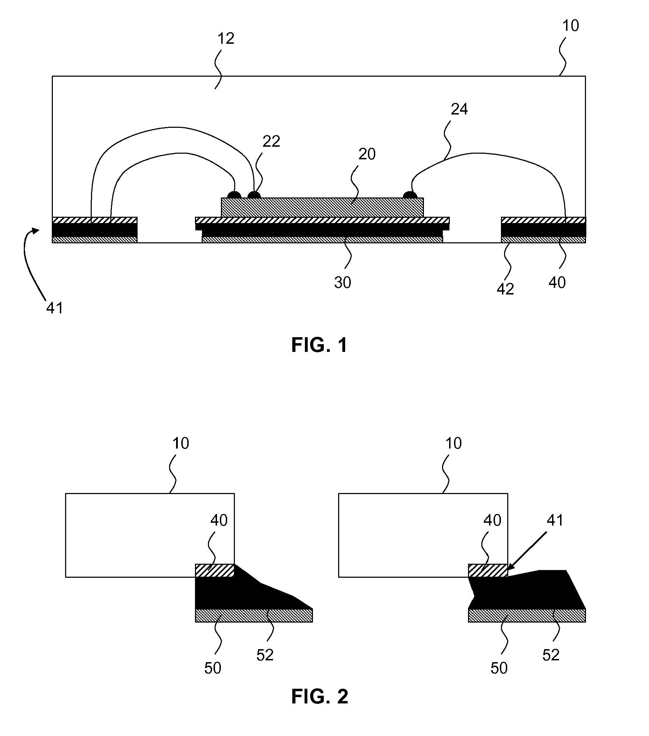

FIG. 1 schematically depicts a leadless package 10 such as a quad flat pack no-lead (QFN) package or a micro dual flat pack no-lead (µDFN) package. The package 10 comprises a die 20 attached to a leadframe 30, which may be attached to the leadframe 30 in any suitable manner, for instance by using an epoxy die attach. The leadframe 30 contains solder contacts 40 for electrically connecting the leadless package 10 to a carrier such as a PCB. The die 20 has contact pads 22 that are connected to the solder contacts 40 via wires 24, which may be made of any suitable material, e.g. gold. It is noted that the contact pads 22 may have any suitable shape, e.g. bumps as shown in FIG. 1.

The leadframe 30 may contain a heat sink or die paddle for providing a die placement area on the leadframe that also functions as a heat conductor from the die to the outside world during operation. The leadframe 30 may be made of any suitable conductive material, such as Cu and alloys thereof. The exposed bottom surface of the leadframe 30 is typically coated, e.g. plated, with a coating or plating 42 of a metal or metal alloy to promote the adhesion of the solder joint to the leadframe 30 including its solder contacts 40. Suitable materials for the coating or plating 42 include Ni/Pd/Au, Sn/Pb, Ni/Au alloys and Sn, with Sn, Ni/Au and Ni/Pd/Au being particularly suitable. Other suitable coating or plating materials will be apparent to the skilled person.

The leadless package 10 further comprises a molding 12, which may be a resinous material such as epoxy, to form a protective upper surface of the leadless package 10, thereby protecting the die 20 from external influences. It will be appreciated that the above description of the leadless package 10 has been provided by way of non-limiting example only, and that many variations are readily available to the skilled person. Such variations will not be discussed for reasons of brevity only.

A typical way of manufacturing a leadless package such as shown in FIG. 1 is by providing a leadframe strip to which a plurality of dies 20 are adhered. The resulting structure is at some stage molded into the resinous material, leaving only the bottom surface of the leadframe strip exposed. Subsequently, the solder-promoting material may be applied to the bottom surface e.g. in a plating step such as electro-less plating and/or immersion plating, after which the individual leadless packages 10 are formed by singulation of the leadframe strip. Several suitable ways of singulating the leadless packages 10 are readily available to the skilled person, such as sawing or punching. The singulated leadless packages 10 are subsequently connected to a carrier such as a PCB by soldering, with the solder joints typically being located between the solder contacts 40 and the corresponding PCB contacts.

As has been mentioned before, such solder joints cannot be easily inspected by automated optical inspection due to the fact that the solder joints may not be sufficiently visible. However, it has been realized by the present inventors that upon singulation, the edge portions 41 of the solder contacts 40 become exposed, which are usually still visible after mounting the leadless package 10 onto a carrier such as a PCB. Hence, by ensuring that the solder joints between the solder contacts 40 and the corresponding contacts of the carrier extend to cover the edge portions 41, the quality of the solder joints between the solder contacts 40 and the corresponding contacts of the carrier may be optically investigated by association, i.e. by optical inspection of the quality of the portion of the solder joint covering the edge portion 41.

Establishing a solder joint portion on the edge portion 41 that is indicative of the quality of the solder joint between the solder contacts 40 and the corresponding contacts of the carrier is however not without problems. For instance, as will have become apparent from the aforementioned description of a typical process flow for the formation of a leadless package 10, only the bottom surface of the lead frame 30 including the surfaces of the solder contacts 40 are treated, e.g. plated, with a solder joint-promoting material. The consequence of this is depicted in FIG. 2. In the left hand pane, a solder joint 52 has successfully formed between the bottom surface of the solder contact 40 and the carrier 50, with the solder joint 52 further covering the edge portion 41 of the solder contact 40. In contrast, in the right hand pane, the solder joint 52 has successfully formed between the bottom surface of the solder contact 40 and the carrier 50, but in this case the edge portion 41 of the solder contact 40 has remained exposed.

Hence, for two different solder joints 52 that both should pass optical inspection, totally different behavior with respect to the coverage of the edge portion 41 may be observed, such that it is clear that the portion of the solder joint covering the edge portion 41 of the solder contact 40 of the leadless package 10 is not guaranteed to be indicative of the quality of the solder joint 52. As will have become apparent from the above brief description of the leadless package manufacturing process, this is due to the fact that the edge portion 41 of the solder contact 40 is not covered by a material for promoting the formation of a solder joint 52 on the covered surface, such that the formation of a solder joint 52 extending over the edge portion 41 cannot be guaranteed.

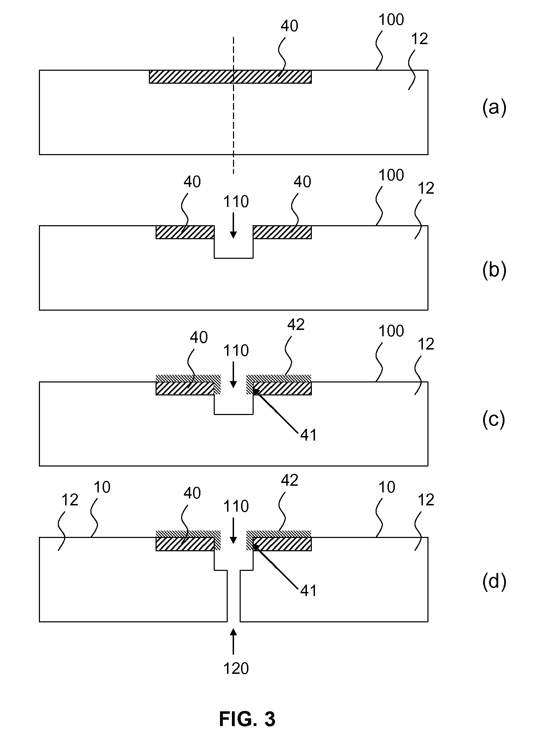

FIG. 3 depicts an embodiment of the method of the present invention in which this problem has been addressed. In step (a), a leadframe strip 100 covered in a molding material 12, e.g. a resin such as an epoxy resin, is provided carrying a number of dies 20 (not shown) and having a number of solder contacts 40 (a single solder contact 40 is shown for reasons of clarity only). The dashed line marks an intended cut area for singulating the respective leadless packages 10.

In step (b), a first singulation trench 110 is formed through the solder contact 40, e.g. by means of a first partial singulation step, which may for instance be a sawing step, to partially singulate the respective leadless packages 10. The trench 110 preferably has a depth such that the edge portion 41 of the solder contact 40 becomes fully exposed. The width of the trench 110 is such that the opposite edge portions 41 at either side of the trench 110 may be covered with a suitable solder joint-promoting material in a plating or other suitable covering step whilst remaining electrically insulated from each other, i.e. with an air gap remaining between the covered opposite edge portions 41.

In step (c), the resulting structure is submitted to a covering step, e.g. a electro-less and/or immersion plating step, in which both the bottom surface as well as the edge portion 41 of the contacts 40 are covered with the solder-joint promoting material 42. As previously disclosed, non-limiting examples of suitable solder-joint promoting materials include Ni/Pd/Au, Sn/Pb, Ni/Au alloys and Sn, with Sn, Ni/Au and Ni/Pd/Au being particularly suitable. Although the present application refers to a single covering step, e.g. an electro-less and/or immersion plating step, it should be understood that it is equally feasible that the solder-joint promoting material 42 is formed on the exposed surfaces of the solder contacts 40 in multiple steps, e.g. multiple plating cycles.

Following the covering of the exposed surfaces of the solder contacts 40 with the solder joint-promoting material 42, the singulation of the leadless packages 10 is completed in step (d), e.g. by means of a second partial singulation step, which may be a second sawing step, in which the trench 120 is formed. Preferably, in case of the partial singulation steps being implemented by sawing, the second sawing step is performed using a saw blade having a thinner edge than the blade used for the first sawing step to facilitate alignment of the saw blade with the trench 110, as a smaller blade ensures that the blade with the trench 110 can be more easily aligned with the wider trench 110, i.e. has alignment tolerances. The resulting leadless packages 10 may be recognized by the stepped edge profile resulting from the two-step sawing process.

The main advantage of the method shown in FIG. 3 is that a single plating or other suitable covering step may be used to form the solder joint-promoting material 42 on the exposed surfaces of the respective solder contacts 40 of the leadless packages 10. However, it is pointed out that this is not essential to the present invention. For instance, in an alternative embodiment, all leadless packages 10 are singulated prior to the formation of the solder joint-promoting material 42 on the exposed surfaces of the respective solder contacts 40, e.g. in a batch process. The resulting leadless packages 10 may be mounted onto a carrier 50 such as a PCB in any suitable manner, wherein the solder joint-promoting material 42 on the edge portion 41 of the solder contacts 40 ensures that the solder joint 52 extends over the edge portion 40 if a good solder joint 52 is established between the solder contact 40 and the corresponding contact of the carrier 50, as long as the edge surface 41 is relatively smooth.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. A method of mounting a leadless chip package (10) on a carrier (50) comprising a plurality of contacts, said package including a package contact (40) bordering an edge (41) of the package for contacting one of said carrier contacts, the method comprising:
providing a portion of said edge (41) with a coating (42) for improving the affinity of the edge to a solder material (52); and
soldering the leadless chip package (10) to one of said carrier contacts using said solder material such that the solder material covers the package contact (40) and the coated edge portion (41).

2. The method of claim 1, further comprising:
providing a strip (100) of the leadless chip packages (10); and
singulating said leadless chip packages, thereby forming the respective edges (41) of said leadless chip packages.

3. The method of claim 2, wherein the step of providing said edge (41) with said coating (42) is performed after said singulation step.

4. The method of claim 2, wherein the steps of singulating said leadless chip packages (10) comprises:
forming a plurality of trenches (110) in said strip (100) by means of a first partial singulation step such that the edge portions (41) of the respective leadless chip packages are exposed;
providing said coating (42) by means of at least one plating step; and
completing said singulation step by means of a second partial singulation step.

5. The method of claim 4, wherein a saw is used in the second partial singulation step having a smaller cutting width than a saw used in the first partial singulation step.

6. The method of any of claims 1-5, wherein the coating (42) is selected from the group of compounds consisting of Sn, Ni/Au and Ni/Pd/Au.

7. The method of any of claims 1-6, wherein said coating (42) is provided by means of a plating step.

8. The method of any of claims 1-7, wherein the leadless chip package (10) is a quad flat non-leaded (QFN) package.

9. The method of any of claims 1-8, further comprising checking the quality of the soldering step by optically inspecting the solder joint (52) covering the coated edge portion (41).

10. An electronic component carrier (50) comprising a plurality of contacts and a leadless chip package (10) having a package contact bordering an edge (41) of the package, said package contact being soldered to one of said plurality of contacts by a solder joint (52), wherein said solder joint extends over a coating covering a portion of said edge (41) for optical inspection of the quality of the solder joint.

11. The electronic component carrier (50) of claim 10, wherein the edge (41) has a stepped profile resulting from a two-step singulation process in which saws with different cutting widths have been used in the respective steps, said stepped profile comprising a recess (110) in the package contact, said recess being covered by said coating.

12. The electronic component carrier (50) of claim 10 or 11, wherein the leadless chip package (10) is a quad flat non-leaded (QFN) package.

13. An apparatus comprising the electronic component carrier (50) of any of claims 10-12.
